# EUROPÄISCHE PATENTSCHRIFT

(11) **EP 0 327 901 B1**
(45) Veröffentlichungstag und Bekanntmachung des Hinweises auf die Patenterteilung: **10.04.1996**
(21) Anmeldenummer: 89101396.3
(22) Anmeldetag: 27.01.1989
(51) Int. Cl.: H01L 29/744, H01L 29/08, H01L 29/36

(54) **Hochleistungs-GTO-Thyristor sowie Verfahren zu dessen Herstellung**
High power GTO thyristor and method of making the same
Thyristor GTO de forte puissance et méthode de fabrication

(30) Priorität: 12.02.1988 CH 520/88
(43) Veröffentlichungstag der Anmeldung: 16.08.1989
(73) Patentinhaber: ASEA BROWN BOVERI AG, CH-5401 Baden (CH)
(72) Erfinder: Roggwiller, Peter, Dr., CH-8173 Riedt-Neerach (CH)

(56) Entgegenhaltungen:
- EP-A- 0 148 065
- WO-A-88/02555
- FR-A- 2 456 389
- FR-A- 2 456 389
- IEEE TRANSACTIONS ON ELECTRON DEVICES, Band ED-31, Nr. 12, Dezember 1984,
- Seiten 1681-1686, IEEE, New York, US; T. YATSUO et al.: "Ultrahigh-voltage high-current gate turn-off thyristors"
- PATENT ABSTRACTS OF JAPAN, Band 7, Nr. 115 (E-176)[1260], 19. Mai 1983, Seite 98 E 176; & JP-A-58 34 966 (HITACHI SEISAKUSHO K.K.) 01-03-1983
- PATENT ABSTRACTS OF JAPAN, Band 7, Nr. 58 (E-163)[1203], 10. März 1983, Seite 100 E 163; & JP-A-57 206 072 (HITACHI SEISAKUSHO K.K.) 17-12-1982

## Beschreibung

### Technisches Gebiet

Die vorliegende Erfindung bezieht sich auf das Gebiet der Leistungs-Halbleiterbauelemente. Sie betrifft insbesondere einen Hochleistungs-GTO-Thyristor mit einer Anode und einer Kathode, umfassend
- zwischen der Kathode und der Anode in einem Halbleitersubstrat eine Schichtenfolge aus einer n-Emitterschicht, einer p-Basisschicht, einer n-Basisschicht und einer p-Emitterschicht; wobei
- die p-Emitterschicht von n-leitenden Anodenkurzschlüssen durchbrochen wird, welche Anodenkurzschlüsse die n-Basisschicht bei hohen Strömen mit der Anode kurzschliessen.

Die Erfindung betrifft weiterhin ein Verfahren zur Herstellung eines Hochleistungs-GTO-Thyristors.

Ein Hochleistungs-GTO-Thyristor ist z.B. aus der EP-A2-0 160 525 bekannt.

### Stand der Technik

Mit Hochleistungs-GTO-Thyristor derzeitiger Bauart können Lastströme von mehreren tausend Ampere durch einen negativen Gatestrom abgeschaltet und Spannungen bis zu 5 kV blockiert werden.

Um die Verluste, die hauptsächlich während des Abschaltvorganges anfallen, klein zu halten, und gleichzeitig eine möglichst hohe Abschaltverstärkung (Verhältnis zwischen abgeschaltetem Laststrom und maximalem Gatestrom) zu gewährleisten, müssen spezielle Massnahmen beim Design und der Herstellung solcher Bauelemente getroffen werden.

Das Ziel derartiger Massnahmen ist es, einerseits die Injektion freier Ladungsträger im leitenden Zustand so gering wie möglich zu halten, und andererseits die Geschwindigkeit für deren Ausräumung beim Abschalten zu erhöhen.

Zu diesem Zweck werden zwei verschiedene Methoden - häufig auch in Kombination - angewendet (siehe die EP-A2-0 160 525);
a) Teilweises Kurzschliessen des anodenseitigen p⁺-Emitters durch Verschachtelung von p⁺- mit n⁺-dotierten Zonen (Anodenkurzschlüssen). Dadurch wird zum einen der wirkungsgrad des Anodenemitters herabgesetzt, und zum anderen können Majoritätsträger beim Abschalten über die n⁺-Kurzschlüsse abfliessen.
b) Reduktion der Minoritätsträgerlebensdauer durch Einbau von Rekombinationszentren z.B. mittels Bestrahlung durch energiereiche Teilchen oder Photonen oder Einduffusion von Schwermetallatomen (Gold). Damit wird ebenfalls eine Reduktion der Injektionshöhe der Ueberschussladungsträger beim Abschalten erreicht.

Beide Massnahmen haben jedoch, neben den gewünschten Effekten, auch ungünstige Einflüsse auf das elektrische Verhalten des GTO-Thyristors zur Folge: In beiden Fällen wird nämlich die Verstärkung des pnp-Teiltransistors im Thyristor reduziert, was insbesondere zu einer Verschlechterung der Zündempfindlichkeit des Thyristors führt.

Besonders gravierend wird dieser Effekt bei Strukturen mit einer starken "Vershortung" des Anodenemitters, da gerade bei kleinen Strömen, wie sie zu Beginn des Einschaltvorgangs fliessen, der Emitterwirkungsgrad stark vermindert wird.

Andererseits ist ein grundsätzlicher Verzicht auf die Anodenkurzschlüsse (shorts) zugunsten der Reduktion der Ladungsträgerlebensdauer nur bei Bauelement-Strukturen für kleine Blokkierspannungen (kleiner 2 kV) sinnvoll, da bei entsprechend dickeren Bauelementen (für höhere Blockierspannungen) die Durchlassspannungen unverhältnismässig gross würden.

Aus Patent Abstracts of Japan, Bd.7, Nr.115 (E-176)[1260], 19. Mai 1983, & JP-A-58 34 966 ist ferner einen GTO-Thyristor bekannt, bei dem n-leitende Kollektorbereiche in der p-leitenden Emitterschicht gebildet werden. Außerdem beschreibt FR-A-2456389 einen Thyristor, bei dem die p-leitende Emitterschicht von n-leitenden Bereichen, durchbrochen wird, und welcher eine niedrig dotierte, p-leitende Schicht zwischen den n-leitenden Bereichen und der n-leitenden Basischicht aufweist.

### Darstellung der Erfindung

Aufgabe der vorliegenden Erfindung ist es daher, einen Hochleistungs-GTO-Thyristor mit Anodenkurzschlüssen zu schaffen, der eine verbesserte Zündempfindlichkeit aufweist, ohne den positiven Einfluss der Anodenkurzschlüsse auf das Abschaltverhalten zu verlieren.

Gemäß Anspruch 1 wird die Aufgabe bei einem Hochleistungs-GTO-Thyristor der eingangs genannten Art dadurch gelöst, dass zumindest innerhalb des den Durchlasstrom führenden Gebietes zwischen den Anodenkurzschlüssen und der n-Basisschicht eine p⁻-Sperrschicht angeordnet ist, deren Dotierungskonzentration weniger als 10¹⁵ cm⁻³ beträgt.

Der Kern der Erfindung besteht also darin, im Thyristor Mittel einzusetzen, welche die Kurzschlusswirkung für kleinere Stromdichten (Zündung) möglichst aufhebt, während diese bei hohen Strömen (Abschalten) wirksam bleibt.

Die niedrig p-dotierte p⁻-Sperrschicht vor den Anodenkurzschlüssen (n⁺-dotiert) ist ein solches Mittel. Sie verhindert zu Beginn des Einschaltvorganges, d.h. bei einer Injektion in der n-Basisschicht, die geringer ist als die Dotierungskonzentration der Sperrschicht, dass Elektronen direkt zur Anoden abfliessen können. Oder anders ausgedrückt: die p⁻-Sperrschicht bewirkt einen hohen Wirkungsgrad des p-Emitters, der derjenigen ohne Anodenkurzschlüsse gleichkommt.

Im Durchlasszustand des GTO-Thyristors und während des Abschaltvorganges ist die p⁻-Sperrschicht vollständig von Ladungsträgern überschwemmt und somit praktisch unwirksam.

Damit beim Abschalten die Kurzschlusswirkung bis zu einem möglichst tiefen Injektionsniveau erhalten bleibt, hat die p⁻-Sperrschicht eine Dotierungskonzentration von weniger als 10¹⁵m⁻³.

Weiterhin ist es vorteilhaft, die p⁻-Sperrschicht mit einer Dicke von nur wenigen Mikrometern auszuführen, um einen hohen Wirkungsgrad des p⁺-Emitters bei kleinen Stromdichten zu gewährleisten.

Gemäß Anspruch 5 betrifft die Erfindung weiterhin ein Verfahren zur Herstellung eines solchen Hochleistungs-GTO-Thyristors.

Das erfindungsgemässe Verfahren zeichnet sich dadurch aus, dass die zum Erzeugen der p⁻-Sperrschicht notwendige Dotierstoffbelegung mittels Ionenimplantation in das Halbleitersubstrat eingebracht wird.

Dies hat den Vorteil, dass die geforderten niedrigen Dotierstoffkonzentrationen mit der nötigen Homogenität und Genauigkeit leicht eingestellt werden können.

Weitere Ausführungsbeispiele der Erfindung ergeben sich aus den Unteransprüchen.

### Kurze Beschreibung der Zeichnung

Die Erfindung soll nachfolgend anhand von Ausführungsbeispielen im Zusammenhang mit der Zeichnung näher erläutert werden. Es zeigen:
- Fig. 1: im Querschnitt den Aufbau einer einzelnen Zelle eines herkömmlichen GTO-Thyristors mit Anodenkurzschlüssen;
- Fig. 2: in zur Fig. 1 entsprechenden Darstellung den Querschnitt durch eine einzelne Zelle eines GTO-Thyristors gemäss einem Ausführungsbeispiel der Erfindung;
- Fig. 3A: den berechneten Verlauf der Dotierungskonzentration entlang der Schnittebene S₁ - S₂ in Fig. 2; und
- Fig. 3B: einen Fig. 3A entsprechenden Konzentrationsverlauf, wie er an einem praktisch erprobten Bauelement gemessen wurde.

### Wege zur Ausführung der Erfindung

Bei einem Hochleistungs-GTO-Thyristor sind in der Regel auf einem grossflächigen Halbleitersubstrat (oder Wafer) nebeneinander eine Vielzahl von einzelnen Thyristorelementen oder Zellen angeordnet.

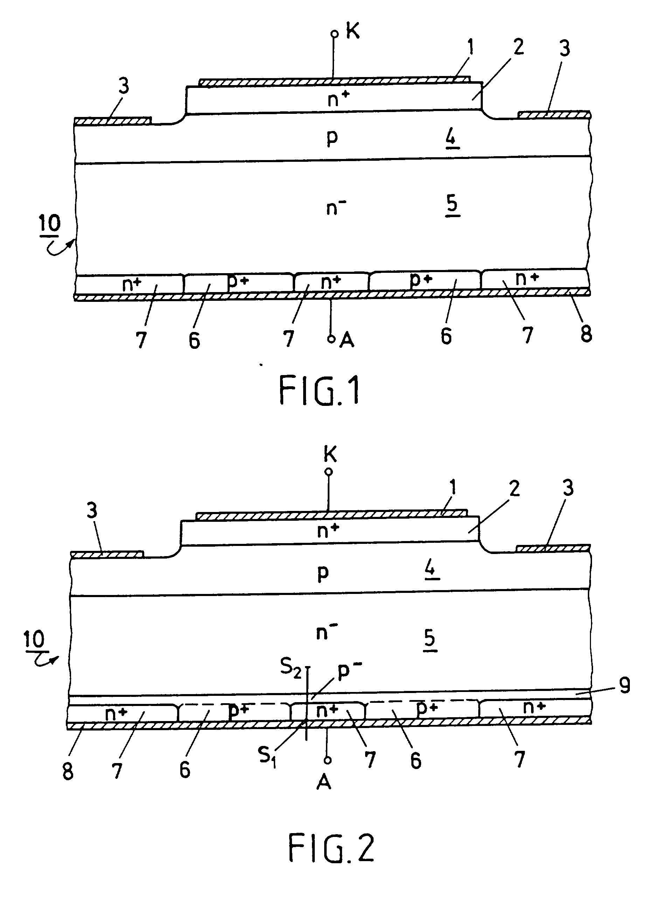

Der Querschnitt durch eine solche einzelne Thyristorzelle ist für einen herkömmlichen GTO-Thyristor mit Anodenkurzschlüssen in Fig. 1 dargestellt.

Zwischen einer Anode A und einer Kathode K ist in dem Halbleitersubstrat 10 eine folge unterschiedlich dotierter Schichten untergebracht, die eine n-Emitterschicht 2 (meist n⁺-dotiert), eine p-Basisschicht 4 (meist p-dotiert), eine n-Basisschicht 5 (meist n⁻-dotiert) und eine p-Emitterschicht 6 (meist p⁺-dotiert) umfasst.

Die p-Emitterschicht 6 wird von verteilt angeordneten Anodenkurzschlüssen 7 (meist n⁺-dotiert) durchbrochen, welche die n-Basisschicht 5 mit der Anode A (bzw. einer Anodenmetallisierung 8, die anodenseitig auf das Halbleitersubstrat 10 aufgebracht ist) kurzschliessen.

Kathodenseitig sind die n-Emitterschicht 2 und die p-Basisschicht 4 durch entpsrechende Metallisierungen, nämlich eine Kathodenmetallisierung 1 und eine Gatemetallisierung 3, kontaktiert.

Von diesem herkömmlichen Aufbau ausgehend gelangt man durch den erfindungsgemässen Einbau einer zusätzlichen p⁻-Sperrschicht 9, deren Dotierungskonzentration weniger als 10¹⁵ cm⁻³ beträgt, zur Darstellung der Fig. 2.

Im Ausführungsbeispiel der Fig. 2 erstreckt sich die nur wenige Mikrometer dicke, p⁻-dotierte p⁻-Sperrschicht 9 lateral nicht nur über die Gebiete der Anodenkurzschlüsse 7, sondern auch über die Gebiete der p-Emitterschicht 6. Dies ist möglich, weil die p⁻-Sperrschicht im Bereich der p-Emitterschicht ohne Einfluss ist.

Auf diese Weise kann die p⁻-Sperrschicht unmaskiert, d.h. besonders einfach, in das Halbleitersubstrat eingebaut werden.

Ein GTO-Thyristor mit der zusätzlichen p⁻-Sperrschicht 9 vor den Anodenkurzschlüssen 7 weist, im Vergleich zur herkömmlichen Struktur nach Fig. 1, eine erhöhte Sperrspannung in Rückwärtsrichtung auf. Sollte dieser Effekt unerwünscht sein, so kann die p⁻-Schicht lokal, d.h. ausserhalb der Durchlassstrom führenden Gebiete weggelassen werden.

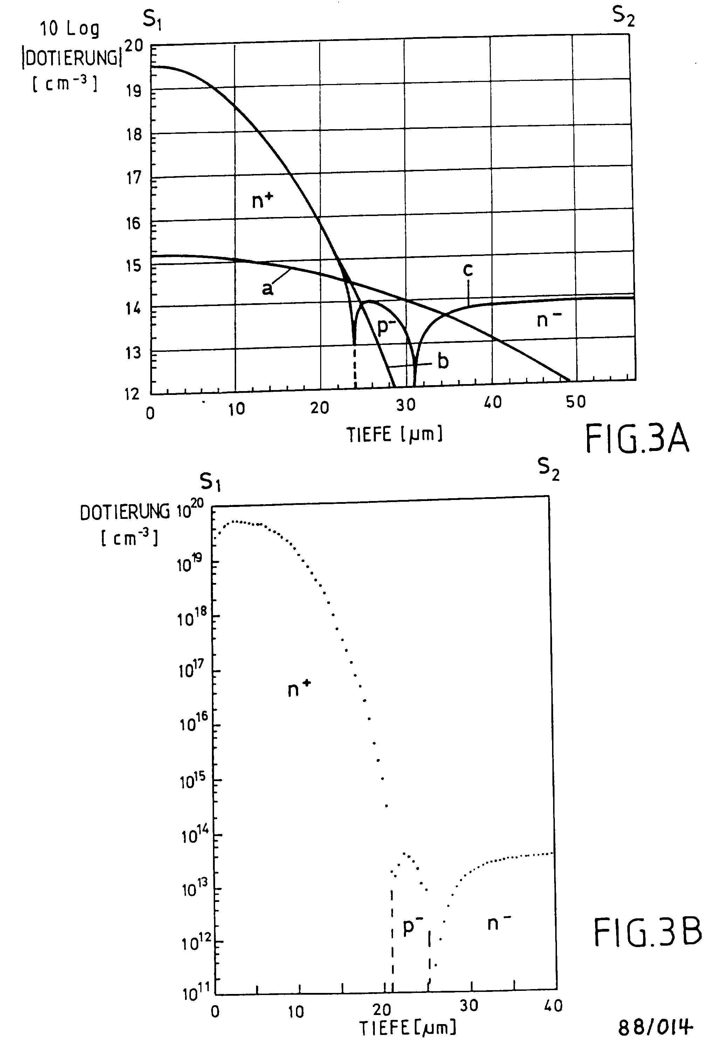

Der Verlauf der Dotierungskonlzentration in einem GTO-Thyristor nach Fig. 2 entlang der Schnittebene durch die dort eingezeichneten Schnittpunkte S₁ und S₂ ist in Fig. 3A (berechnet) und in Fig. 3B (gemessen) wiedergegeben.

Der Konzentrationsverlauf (Kurve c in Fig. 3A) setzt sich zusammen aus der n⁻-Grunddotierung des Halbleitersubstrats (etwa 10¹⁴ cm⁻³ im rechten Teil der Figur) und den von der Anodenseite zusätzlich eingebrachten p⁻-Dotierungen (Kurve a) und n⁺-Dotierungen (Kurve b).

Wie man leicht erkennt, hat im berechneten Verlauf (Fig. 3A) die p⁻-Sperrschicht eine maximale Dotierungskonzentration von etwa 10¹⁴ cm⁻³ und eine Dicke von etwa 7 Mikrometern.

Aehnliche Verhältnisse werden tatsächlich in realisierten Bauelementen erreicht, wie die "Spreading resistance"-Messung in Fig. 3B zeigt. Hier liegt die Konzentration in der p⁻-Sperrschicht bei etwa 4 · 10⁻¹³ cm⁻³ und deren Dicke bei etwa 4 Mikrometern.

Die Dotierstoffbelegung für diese p⁻-Sperrschicht erfolgt dabei durch Ionenimplantation, da damit die geforderten, niedrigen Konzentrationen mit der nötigen Homoglenität leicht eingestellt werden können.

Erste experimentelle Untersuchungen an 600-A-GTO-Thyristoren haben gezeigt, dass mit der erfindungsgemässen Struktur der minimale Zündstrom bei Raumtemperatur um mindestens einen Faktor fünf reduziert werden kann, ohne das Ausschaltenverhalten nennenswert zu beeinflussen.

Es ist also mit der Erfindung möglich, die ungünstige Wirkung von Anodenkurzschlüssen bei Hochleistungs-GTO-Thyristoren auf deren Einschaltverhalten weitgehend zu vermeiden.

## Patentansprüche

1. Hochleistungs-GTO-Thyristor mit einer Kathode (K) und einer Anode (A), umfassend
a) zwischen der Kathode (K) und der Anode (A) in einem Halbleitersubstrat (10) eine Schichtenfolge aus einer n-leitenden Emitterschicht (2), einer p-leitenden Basisschicht (4), einer n-leitenden Basisschicht (5) und einer p-leitenden Emitterschicht (6); wobei
b) die p-leitende Emitterschicht (6) von n-leitenden Bereichen (7) durchbrochen wird, welche n-leitenden Bereiche (7) die n-leitende Basisschicht (5) bei hohen Strömen mit der Anode (A) kurzschliessen;
dadurch gekennzeichnet, dass
c) zumindest innerhalb des den Durchlassstrom führenden Gebietes zwischen den n-leitenden Bereichen (7) und der n-leitenden Basisschicht (5) eine zusätzliche, niedrig dotierte, p-leitende Sperrschicht (9) angeordnet ist, deren Dotierungskonzentration weniger als 10¹⁵ cm⁻³ beträgt.

2. GTO-Thyristor nach Anspruch 1, dadurch gekennzeichnet, dass die p-leitende Sperrschicht (9) eine Dicke von wenigen Mikrometern aufweist.

3. GTO-Thyristor nach Anspruch 2, dadurch gekennzeichnet, dass sich die p-leitende Sperrschicht (9) lateral über die ganze Fläche des Thyristors erstreckt.

4. GTO-Thyristor nach Anspruch 2, dadurch gekennzeichnet, dass die p-leitende Sperrschicht (9) lateral auf das den Durchlassstrom führende Gebiet beschränkt ist.

5. Verfahren zum Herstellen eines GTO-Thyristors nach Anspruch 1, dadurch gekennzeichnet, dass die zum Erzeugen der p-leitenden Sperrschicht (9) notwendige Dotierstoffbelegung mittels Ionenimplantation in das Halbleitersubstrat (10) eingebracht wird.

## Claims

1. High-power GTO thyristor having a cathode (K) and an anode (A), comprising
a) a layer sequence comprising an n-conducting emitter layer (2), a p-conducting base layer (4), an n-conducting base layer (5) and a p-conducting emitter layer (6) between the cathode (K) and the anode (A) in a semiconductor substrate (10);
b) the p-conducting emitter layer (6) being perforated by n-conducting regions (7), which n-conducting regions (7) short-circuit the n-conducting base layer (5) to the anode (A) at high currents, characterized in that
c) an additional, lightly doped p-conducting barrier layer (9), the doping concentration of which amounts to less than 10¹⁵cm⁻³, is disposed at least inside the region carrying the on-state currents between the n-conducting regions (7) and the n-conducting base layer (5).

2. GTO thyristor according to Claim 1, characterized in that the p-conducting barrier layer (9) has a thickness of a few micrometers.

3. GTO thyristor according to Claim 2, characterized in that the p-conducting barrier layer (9) extends laterally over the entire area of the thyristor.

4. GTO thyristor according to Claim 2, characterized in that the p-conducting barrier layer (9) is restricted laterally to the region carrying the on-state current.

5. Process for manufacturing a GTO thyristor according to Claim 1, characterized in that the dopant deposition necessary to produce the p-conducting barrier layer (9) is introduced into the semiconductor substrate (10) by means of ion implantation.

## Revendications

1. Thyristor GTO de forte puissance avec une cathode (K) et une anode (A), comportant
(a) entre la cathode (K) et l'anode (A), à l'intérieur d'un substrat semi-conducteur (10), une succession de couches comprennant une couche émetteur (2) de type conducteur n, une couche de base (4) de type conducteur p, une couche de base (5) de type conducteur n et une couche émetteur (6) de typeconducteur p ; à ce propos
b) la couche émetteur (6) de type conducteur p est interrompue par des zones (7) de type conducteur n, ces zones (7) de type conducteur n court-circuitant la couche de base (5) de type conducteur n avec l'anode (A) pour les forts courants ;
caractérisé en ce que
c) au moins à l'intérieur de la zone conduisant le courant de passage, entre les zones (7) de type conducteur n et la couche de base (5) de type conducteur n, est disposée une couche supplémentaire d'arrêt (9) de type conducteur p, faiblement dopée, dont la concentration de dopage est inférieure à 10¹⁵ cm⁻³.

2. Thyristor GTO suivant la revendication 1, caractérisé en ce que la couche d'arrêt (9) de type conducteur p présente une épaisseur de quelques microns.

3. Thyristor GTO suivant la revendication 2, caractérisé en ce que la couche d'arrêt (9) de type conducteur p s'étende latéralement sur toute la surface du thyristor.

4. Thyristor GTO suivant la revendication 2, caractérisé en ce que la couche d'arrêt (9) de type conducteur p soit limitée latéralement à la zone conduisant le courant de passage.

5. Procédé de fabrication d'une thyristor GTO suivant la revendication 1, caractérisé en ce que le dépôt du matériau de dopage nécessaire à la réalisation de la couche d'arrêt (9) de type conducteur p, est introduit dans le substrat semi-conducteur (10) par implantation ionique.
